**Europäisches Patentamt**

**European Patent Office**

**Office européen des brevets**

(19)

(11) Veröffentlichungsnummer: **0 242 911**

**A1**

(12) # EUROPÄISCHE PATENTANMELDUNG

(21) Anmeldenummer: **87200667.1**

(22) Anmeldetag: **08.04.87**

(51) Int. Cl.⁴: **G01N 24/08**

(30) Priorität: **21.04.86 NL 8601002**

(43) Veröffentlichungstag der Anmeldung:
**28.10.87 Patentblatt 87/44**

(84) Benannte Vertragsstaaten:
**BE CH DE FR GB LI**

(71) Anmelder: **N.V. Philips' Gloeilampenfabrieken
Groenewoudseweg 1
NL-5621 BA Eindhoven(NL)**

(72) Erfinder: **Den Boef, Johannes Hendrik
c/o INT. OCTROOIBUREAU B.V. Prof.
Holstlaan 6
NL-5656 AA Eindhoven(NL)**
Erfinder: **van Eggermond, Johannes Maria
c/o INT. OCTROOIBUREAU B.V. Prof.
Holstlaan 6
NL-5656 AA Eindhoven(NL)**
Erfinder: **van Uijen, Cornelis Marinus
Johannes
c/o INT. OCTROOIBUREAU B.V. Prof.
Holstlaan 6
NL-5656 AA Eindhoven(NL)**

(74) Vertreter: **Faessen, Louis Marie et al
INTERNATIONAAL OCTROOIBUREAU B.V. 6
Prof. Holstlaan
NL-5656 AA Eindhoven(NL)**

(54) **Verfahren und Anordnung zur Bestimmung einer Kernmagnetisierungsverteilung in einem Teil eines Körpers.**

(57) Die Erfindung betrifft ein Verfahren und eine Anordnung, mit denen ein Bild einer Kernmagnetisierungsverteilung in einem Körper bestimmt wird. Bei bekannten Verfahren, insbesondere bei Kernspinechotechniken, wird ein Resonanzsignal mit grosser Dynamik erzeugt. Beim erfindungsgemässen Verfahren wird eine nicht-lineare, stellenabhängige, oder eine innerhalb einer Spektroskopieverteilung der Frequenz abhängige Phasenzerstreuung bewirkt, wodurch das erzeugte Resonanzsignal eine viel kleinere Amplitude haben wird. Da die innerhalb der Verteilung angelegte nicht-lineare Phasenzerstreuung bekannt ist, kann dafür nach der Bestimmung der Messsignale eine Korrektur durchgeführt werden. Die nicht-lineare Phasenzerstreuung kann mittels Anregungsimpulse und/oder mit folgenden Kernspinechoimpulsen (auch Refokussierungsimpulse) bewirkt, die ein Frequenzspektrum mit einem nicht-linear verlaufenden Phasengang besitzen (ggf. bei Vorhandensein eines Gradientenmagnetfelds) oder mit Hilfe eines beispielsweise während der Vorbereitungsperiode zuzuführenden, nicht-linear stellenabhängigen zusätzlichen Magnetfelds. Das anzulegende, nicht-lineare zusätzliche Magnetfeld besitzt vorzugsweise Komponenten höherer Ordnung, wie z.B. quadratische Komponenten. Die zu erzielende Signaldynamikverringerung ist von der (Frequenz oder) Stellenabhängigkeit nicht-linearer Phasenzerstreuung abhängig. Wird in einem Bild von n x n Bildelementen beispielsweise ein nicht-linear stellenabhängiges zusätzliches Magnetfeld benutzt, das von zwei Koordinaten abhängig ist, so ist eine maximal zu erreichende Signaldynamikverringerung gleich $\sqrt{n \times n}$ möglich.

EP 0 242 911 A1

FIG.4a

FIG.4b

## "Verfahren und Anordnung zur Bestimmung einer Kernmagnetisierungsverteilung in einem Teil eines Körpers".

Die Erfindung betrifft ein Verfahren zur Bestimmung einer Kernmagnetisierungsverteilung in einem Teil eines Körpers, bei dem ein homogenes statisches Magnetfeld erzeugt wird, in dem sich der Teil des Körpers befindet, und

a) ein hochfrequenter elektromagnetischer Impuls zum Erzeugen eines Resonanzsignals erzeugt wird,

b) wobei nach einer Vorbereitungszeit während einer Messzeit eines erzeugten Resonanzsignals eine Anzahl von Signalproben genommen wird,

c) wonach die Schritte a) und b) zum Erhalten einer Gruppe von Signalproben mehrere Male wiederholt werden, aus denen nach der Transformation der Signale ein Bild der Verteilung der Kernmagnetisierung bestimmt wird.

Die Erfindung bezieht sich weiter auf eine Anordnung zur Bestimmung einer Kernmagnetisierungsverteilung in einem Teil eines Körpers, wobei die Anordnung

a) Mittel zum Erzeugen eines statischen homogenen Magnetfelds,

b) Mittel zum Erzeugen hochfrequenter elektromagnetischer Strahlung, deren magnetischer Feldrichtung senkrecht zur Feldrichtung des homogenen Magnetfelds verläuft,

c) Mittel zum Erzeugen eines Gradientenmagnetfelds,

d) Abtastmittel zum Abtasten eines mit den unter a) und b) genannten Mitteln erzeugten Resonanzsignals,

e) Verarbeitungsmittel zum Verarbeiten der von den Abtastmitteln gelieferten Signale zu einem Bild der Kernmagnetisierungsverteilung, und

f) Steuermittel zum Steuern zumindest der unter b) bis e) genannten Mittel zum Erzeugen, Konditionieren, Abtasten und Verarbeiten einer Anzahl von Resonanzsignalen enthält.

Derartige Verfahren (auch Kernspintomographie genannt) und Anordnungen sind aus der US-PS 4 070 611 sowie aus der niederländischen Patentanmeldung 82 03519 und aus der europäischen Patentanmeldung 074 022 bekannt. Bei den erwähnten Verfahren tritt der Zustand ein, dass die erzeugten Resonanzsignale einen grossen dynamischen Bereich haben. Es wird häufig die sog. Kernspinechotechnik angewandt, was den Vorteil bietet, dass die Magnetisierungen der Kernspins zu einem bestimmten Zeitpunkt alle phasengleich sind, wodurch Signalverlust durch Phasenzerstreuungen innerhalb eines Bildelements vermieden wird. Weiter können vor der Durchführung der Messungen die Gradientenmagnetfelder genau abgeglichen werden. Wird jedoch keine Kernspinechotechnik angewandt, so zeigt es sich erst nachher, ob die Gradientenmagnetfelder gut abgeglichen wurden, wodurch manchmal erneut Messungen durchgeführt werden müssen.

Ein weiterer Vorteil der Anwendung einer Kernspinechotechnik ist die Möglichkeit, die erforderliche Anzahl von Messungen zum Codieren des Bildes um etwa die Hälfte herabzusetzen. Ein Nachteil der Kernspinechotechnik ist jedoch, dass während der Messungen die Signale amplitudenmässig sehr stark abweichen können. Aus diesem Grund werden sehr hohe Anforderungen an den dynamischen Bereich der Detektionsgeräte gestellt. So ist es möglich, dass bei Messungen ziemlich grosser Volumina (beispielsweise einer 10 cm dicken Scheibe des Kopfes) bei hohen Feldstärken von beispielsweise 0,5 Tesla ein dynamischer Bereich von etwa 20 Bits erforderlich ist. Dies ist sehr schwer verwirklichbar.

Der Erfindung liegt die Aufgabe zugrunde, ein Verfahren und eine Anordnung zu schaffen, in denen wesentlich leichtere Anforderungen an den dynamischen Bereich der Detektionsgeräte gestellt werden können, während dennoch alle Vorteile der Kernspinechotechnik und anderer Messtechniken aufrechterhalten bleiben.

Zur Lösung dieser Aufgabe ist ein erfindungsgemässes Verfahren dadurch gekennzeichnet, dass mit einem Magnetfeld eine innerhalb der Verteilung nicht-linear verlaufende Phasenzerstreuung angeregter Kernmagnetisierungen erzeugt wird, und dass zur Bestimmung des Bildes der Kern magnetisierungsverteilung die auf diese Weise erzeugte stellenabhängige Phasenzerstreuung ausgeglichen wird.

Zur Lösung dieser Aufgabe ist weiter eine erfindungsgemässe Anordnung dadurch gekennzeichnet, dass die Anordnung weitere Mittel zum Erzeugen einer innerhalb der Verteilung nicht linear verlaufenden Phasenzerstreuung angeregter Kernmagnetisierungen und weiter Mittel zum Ausgleichen dieser Phasenzerstreuung enthält.

Wenn die zu bestimmende Verteilung eine stellenabhängige Verteilung ist (beispielsweise eine zweidimensionale Dichteverteilung), muss die nicht lineare Phasenzerstreuung stellenabhängig sein. Ist die zu bestimmende Verteilung eine Spektroskopieverteilung, wird die nichtlineare Phasenzerstreuung innerhalb des Spektrums angebracht und somit frequenzabhängig sein. Selbstverständlich ist eine Kombination dieser beiden Möglichkeiten ebenfalls verwirklichbar.

Ein Ausführungsbeispiel eines erfindungsgemässen Verfahrens ist dadurch gekennzeichnet, dass in der Vorbereitungszeit ein inhomogenes, nicht lineares stellenabhängiges zusätzliches Magnetfeld angelegt wird.

Im beschriebenen Verfahren wird in der Vorbereitungszeit zwischen Anregung und Messzeit, in der die Detektion des Resonanzsignals erfolgt, eine gewollte Feldinhomogenität derart eingeführt, dass zum Zeitpunkt, zu dem ohne diese Feldinhomogenität ein maximales Resonanzsignal auftreten würde, beispielsweise ein Echosignal bei Kernspinechotechnik, die Magnetisierungen der Bildelemente untereinander phasenungleich sind. Es ist jedoch dafür zu sorgen, dass in einem Bildelement keine zu starke Phasenzerstreuung auftritt. Bei einer Bildmatrix von n x n Bildelementen und einer beliebigen Orientierung der Magnetisierungen der Bildelemente sinkt die Signalstärke des Resonanzsignals mit $\sqrt{n \times n^1} = n$ ab. Für n = 128 (= $2^7$) bedeutet dies eine Reduzierung der Signaldynamik um 7 Bits.

Ein Ausführungsbeispiel eines erfindungsgemässen Verfahrens ist dadurch gekennzeichnet, dass die Stärke des zusätzlichen Magnetfelds mit zumindest einem von drei zusätzlichen Teilmagnetfeldern erzeugt wird, die von je einer von drei untereinander senkrecht zueinander verlaufenden Richtungskoordinaten abhängig sind. Entsprechend dem Ausführungsbeispiel ist es wünschenswert, dass die eingeführten Inhomogenitäten des zusätzlichen Magnetfelds nicht die Form eines linearen Gradienten haben (d.h. die Inhomogenität ist x, y, z oder linearen Kombinationen von x, y, z proportional), weil dabei das Auftreten einer grossen Signalstärke des Resonanzsignals nach einem anderen Zeitpunkt verschoben wird. Die eingeführte Inhomogenität soll somit aus Komponenten höherer Ordnungen bestehen. Es ist ebenfalls möglich, die bestehenden Inhomogenitäten im bereits verfügbaren statischen Magnetfeld zu verwenden. Jedoch hat dies den Nachteil, dass der Abgleich der Gradientenmagnetfelder dabei ein mühsamer Vorgang ist. Werden zusätzliche Inhomogenitäten benutzt, die mit den dazu angebrachten zusätzlichen Mitteln erzeugt werden, tritt dieses Problem nicht auf. Denn es ist dabei möglich, die Gradientenmagnetfelder abzugleichen, während die Spulen zum Erzeugen des nicht-linearen zusätzlichen Magnetfelds nicht erregt sind. Erst in den endgültigen Messungen werden dann für die Signaldetektion die erwähnten zusätzlichen Magnetfeldinhomogenitäten erzeugt. Während der Signaldetektion sind die zusätzlichen Mitteln ebensowenig aktiv, so dass dadurch keine Bildverzerrung oder Unschärfe entstehen kann.

Im allgemeinen entfällt bei obigem Verfahren die Möglichkeit, im Kernspintomographieverfahren (siehe niederländische Patentanmeldung 82 03519) die Anzahl der Messungen um etwa die Hälfte zu verringern. Wird bei einem Ausführungsbeispiel des Verfahrens jedoch ein derartig stellenabhängiges, nicht lineares zusätzliches Magnetfeld verwendet, dessen Feldstärke von nur einer Koordinatenrichtung abhängig ist, kann man dennoch mit der Hälfte der Datenanzahl auskommen. In der Praxis wird der Versuch derart durchgeführt, dass dies auch eine Verringerung um den Faktor 2 der Anzahl von Messungen bedeutet. Ein Beispiel davon ist ist ein zweidimensionaler Versuch im Kernspintomographieverfahren, bei dem ein Objekt in der xy-Ebene dadurch abgebildet wird, dass die Magnetisierungen nach der Anregung mit einem Gradientenfeld Gy in der Anordnung einen Phasenwinkel proportional der y-Koordinate mitgegeben (abgesehen von der nicht linearen Phasenverschiebung) und danach das MRI-Signal bei einem Gradienten Gx in der x-Richtung detektiert wird. Für eine Auflösung von n Teilpunkten in der y-Richtung muss dieses Schema im allgemeinen n-mal wiederholt werden, jedoch mit einer stets verschiedenen Stärke des Zeitintegrals des Gradientenmagnetfelds Gy. Wird in einem Ausführungsbeispiel des Verfahrens ein nicht lineares zusätzliches Magnetfeld verwendet, das nur von der x-Koordinate abhängig ist, so reicht eine Anzahl von Wiederholungen gleich $\frac{n}{2}$ + 1, wenn n geradzahlig ist, oder gleich $\frac{n+1}{2}$, wenn n ungeradzahlig ist, zur Bestimmung eines vollständigen Bildes aus.

Ein Ausführungsbeispiel eines erfindungsgemässen Verfahrens ist dadurch gekennzeichnet, dass ein benutzter Hochfrequenzimpuls ein nicht-linear verlaufendes Phasenspektrum hat.

Ein bevorzugtes Ausführungsbeispiel eines erfindungsgemässen Verfahrens ist dadurch gekennzeichnet, dass die Gradientenrichtung eines während des Hochfrequenzechoimpulses mit einem nicht linear verlaufenden Phasenspektrum vorhandenen Gradientenmagnetfelds mit der Gradientenrichtung eines während der Messzeit anzulegenden linearen Gradientenmagnetfelds zusammenfällt. Im Verfahren nach dem bevorzugten Ausführungsbeispiel bleibt die Möglichkeit erhalten, bei der Ausnutzung von (dreidimensionaler) Kernspintomographie die Anzahl der Messzyklen in an sich bekannter Weise auf (etwa) die Hälfte zu verringern. Obige Beschreibung ist klar im Hinblick auf die Tatsache, dass nach der Messung und nach der Fourier-Transformation der Signalproben aus einem Messzyklus die eingeführte (nicht-lineare) stellenabhängige Phasenzerstreuung ausgleichbar ist, wodurch ein Spektrum erhalten wird, das gleich dem Spektrum ist, das ohne das Einführen der stellenabhängigen Phasenzerstreuung gemessen werden würde.

Bei dreidimensionaler Kernspintomographie ist es vorteilhaft, die Kernspins auf nicht-lineare Weise und in zwei senkrecht zueinander verlaufenden Richtungen stellenabhängig in der Phase zu zerstreuuen. Zur Verwirklichung haben sowohl der 90°-Anregungsimpuls als auch der nächste 180°-(Refokussierungsimpuls)-Echoimpuls einen nicht linear verlaufenden Frequenzgang. Ein beim 90°-Anregungsimpuls vorhandes lineares Gradientenmagnetfeld hat eine Gradientenrichtung, die senkrecht zur Gradientenrichtung des beim Echoimpuls vorhandenen linearen Gradientenmagnetfelds verläuft.

Ein Ausführungsbeispiel des erfindungsgemässen Verfahrens geht wie folgt. In einem ersten Messzyklus werden keine Vorbereitungsgradientenfelder eingeschaltet. Die Fourier-Transformation des abgetasteten Resonanzsignals liefert ein vollständiges Spektrum von Frequenzelementen, in dem je Frequenzelement die Phase ermittelt wird. Diese Phase ist, abgesehen von einen möglichen konstanten Phasenfehler $\phi_0$, der durch eine falsche Einstellung der Detektoranordnung verursacht wird, vollständig durch die vorgegebene (stellenabhängige) Phasenzerstreuung bestimmt. Die ermittelten Phasenwinkel des gemessenen Resonanzsignals werden in einen Speicher eingeschrieben. Hiernach können die gespeicherten Phasenwinkel auf zwei Weisen verarbeitet werden. Auf eine erste Weise wird auf allen Messungen nach ihrer Fourier-Transformation eine Phasenkorrektur entsprechend den im Speicher geschriebenen Phasenwinkeln durchgeführt. Auf die zweite Weise folgt der Fourier-Transformation aller Messungen, d.h. der Fourier-Transformation der Zeilen, eine Fourier-Transformation der Punkte aus mehreren Messungen, die aber zur selben Frequenz gehören (d.h. Fourier-Transformation der Spalten), wonach nach Ausnutzung dieses zweidimensionalen Fouriertransformationsalgorithmus eine Phasenkorrektur je Bildelement an dem bereits dann bestimmten vorläufigen Bild durch geführt wird. Dies geschieht entsprechend den im Speicher gespeicherten Phasenwinkeln. Die Korrektur ist dabei eine Phasendrehung, die spaltenweise konstant ist, was bedeutet, dass sie beispielsweise nur von der x-Koordinate abhängig ist. Erst nach der erforderlichen Phasendrehung in jedem Bildelement ist das gewünschte Bild verwirklicht. Bei der Verwendung eines nicht-linearen, zusätzlichen Magnetfelds, das von nur einer Koordinate abhängig ist, ist jedoch eine geringere Signalstärkeverringerung erreicht. Bei einer n x n Matrix nimmt die Signalstärke im vorteilhaftesten Fall nur um $\sqrt{n}$ statt $\sqrt{n \times n}$ ab.

Wenn die stellenabhängige Phasenzerstreuung sowohl von der Koordinate x als auch von y abhängig ist, ist nach der Rekonstruktion aus dem reellen und dem komplexen vorläufigen Bild je Bildelement die Phasendrehung bestimmbar und dafür korrigierbar. Ggf. wird zuvor die Phasenkorrektur in einer Kalibriermessung bestimmt und sie wird in einen Computerspeicher eingeschrieben. Es sei bemerkt, dass das Verfahren auf jede beliebig orientierte Fläche anwendbar ist, was seinen Einfluss auf den Nutzen des Einschreibens von Phasenkorrekturen hat. Wenn ein dreidimensionales Bild bestimmt wird, sieht ein Verfahren nach der Erfindung wie folgt aus. Angenommen sei, dass das Signal bei einem Gradientenmagnetfeld Gx gemessen wird, und dass die Gradientenmagnetfelder Gy und Gz als Vorbereitungsgradienten geschaltet werden. Bei der Messung einer nx x ny x nz-Matrix wird die Signalstärke im Idealfall, bei dem die Magnetisierungen untereinander beliebig orientiert werden, mit Hilfe der stellenahängigen Phasenzerstreuung um den Faktor gleich $\sqrt{nx \times ny \times nz}$ verringert. Bei der Rekonstruktion des dreidimensionalen Bildes wird jetzt nach der dreidimensionalen Fourier-Transformation je Volumeneinheit für die eingeführte stellenabhängige Phasenzerstreuung und ggf. auch für den konstanten Detektorphasenwinkel $\phi_0$ eine Korrektur durchgeführt.

Auch ist es im dreidimensionalen Fall möglich, mit etwa die Hälfte der Anzahl von Messungen auszukommen. Dabei ist es jedoch notwendig, dass die stelleabhängige Phasenzerstreuung dabei von nur zwei Koordinaten abhängig ist. So kann beispielsweise die stellenabhängige Phasenzerstreuung nur von den x-und z-Koordinaten abhängig sein, wobei dann der Zyklus, dem in der Messung gefolgt wird, derart ist, dass das Gradientenmagnetfeld Gy die Hälfte seiner Anzahl von Werten durchläuft. Nach der dreidimensionalen Fourier-Transformation wird dann der gewollte eingeführte Phasenfehler korrigiert, der nur von den x-und z-Koordinaten abhängig ist. Diese Korrektur kann auch durchgeführt werden, bevor die Fourier-Transformation, die die Bilddaten abhängig von der y-Koordinate ergibt, angewandt ist. Die Verringerung in der Signalstärke ist jetzt im Idealfall der Faktor gleich $\sqrt{nx \times nz}$ also kleiner als die Anwendung von Feldinhomogenitäten in drei Richtungen.

Es wird klar sein, dass, obgleich die Erfindung stets anhand des bekannten Kernspinresonanzverfahrens erläutert wurde, diese Erfindung auch bei anderen Bildrekonstruktionsmethoden anwendbar ist, bei denen Kernspinresonanzsignale ausgenutzt werden, wie beispielsweise bei Projektionsrekonstruktionsverfahren (siehe beispielsweise Philips Technisch Tijdschrift, Jahrgang 41, Nr. 3, 1983, S. 73... 89) und Bestimmungen von Spektroskopieverteilungen.

Ein Ausführungsbeispiel einer erfindungsgemässen Anordnung ist dadurch gekennzeichnet, dass die Mittel zum Erzeugen einer innerhalb der Verteilung nicht-linear verlaufenden Phasenzerstreuungspulen zum Erzeugen eines nichtlinear stellenabhängigen zusätzlichen Magnetfelds enthalten. Eine derartige Anordnung bietet den Vorteil, dass Dynamikverringerung des zu messenden Kernspinresonanzsignals verwirklichbar ist, bei dem die nicht-linear verlaufende Phasenzerstreuung durch Spulen bewirkt wird, die von den für die an sich bekannten MRI-Messungen erforderlichen Mitteln unabhängig sind, wodurch die letztgenannten Mittel auf die an sich bekannte(n) Weise(n) einstellbar und verwendbar sind.

Ein bevorzugtes Ausführungsbeispiel einer erfindungsgemässen Anordnung ist dadurch gekennzeichnet, dass die Anordnung Hochfrequenzmittel zum Erzeugen von Hochfrequenzimpulsen mit einem nicht-linearen Phasenspektrum enthält, wobei die Hochfrequenzmittel einen Einseitenbandmodulator enthalten. Auch beim bevorzugten Ausführungsbeispiel der Anordnung besteht der Vorteil, dass die für die an sich bekannten MRI-Messungen erforderlichen Mittel unabhängig von der nicht-linear verlaufenden (stellen-oder frequenzabhängigen) Phasenzerstreuung bewirkende Hochfrequenzmittel einstellbar und verwendbar sind. Den Hochfrequenzmitteln können viele Arten von Steuersignalen zugeführt werden, so dass verschiedene gewünschte Spektren möglicherweise mit einem nicht-linear verlaufenden Phasengang erzeugbar sind.

Ein Ausführungsbeispiel einer erfindungsgemässen Anordnung ist dadurch gekennzeichnet, dass die Anordnung Speichermittel zum Speichern von Werten zum Ausgleichen der Phasenzerstreuungen enthält.

Eine derartige Anordnung bietet den Vorteil, dass nicht stets erneut die Werte zum Ausgleichen der Phasenzerstreuungen errechnet werden müssen, wodurch eine schnellere Verarbeitung von Daten und eine schnellere Verwirklichung eines Bildes möglich gemacht wird.

Eine weiteres Ausführungsbeispiel einer erfindungsgemässen Anordnung ist dadurch gekennzeichnet, dass die Speichermittel zum Einschreiben der Ausgleichswerte eine Anzahl von Speicherstellen enthalten, die gleich der Anzahl von Bildelementen in einer Dimensionsrichtung eines mehrdimensionalen Bildes ist. Dieses Ausführungsbeispiel bietet den Vorteil, dass man mit einem verhältnismässig geringen Volumen des Speichers für die Ausgleichswerte auskommen kann. Jedoch ist es dabei so, dass nur in jener einen Dimensionsrichtung eine Signalverringerungsphasenzerstreuung eingeführt werden darf.

Es sei bemerkt, dass die Verwendung eines Einseitenbandmodulators an sich (unabhängig von der Erfindung) schon vorteilhaft ist, weil or bei mehreren Messmethoden, beispielsweise bei Spektroskopie und bei "multiple slice" nutzhaft einsetzbar ist.

Ausführungsbeispiele der Erfindung werden nachstehend anhand der Zeichnung näher erläutert. Es zeigen

Fig. 1 schematisch eine erfindungsgemässe Anordnung,

Fig. 2 ein erfindungsgemässes Verfahren,

Fig. 3a und b graphische Darstellungen eines Hochfrequenzimpulses und seiner Frequenzgänge nach dem Stand der Technik,

Fig. 4a und b graphische Darstellungen eines Hochfrequenzimpulses und seiner Frequenzgänge nach der Erfindung, und

Fig. 5 auf schematische Weise, wie ein Hochfrequenzimpuls mit einem nicht-linear verlaufenden Phasenspektrum erzeugbar ist.

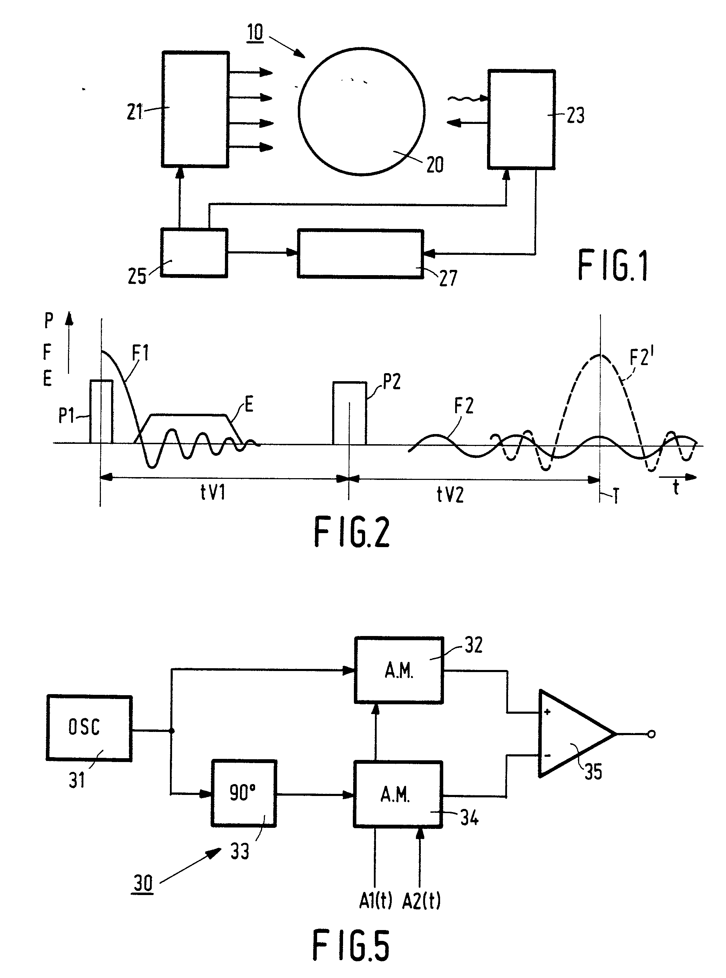

In Fig. 1 ist schematisch eine Anordnung 10 nach der Erfindung dargestellt, die ein Spulensystem 20 und eine Spulensteueranordnung 21 enthält, die Stromgeneratoren zum Ansteuern von Hauptspulen zum Erzeugen eines einheitlichen statischen Hauptfeldes BO und zum Ansteuern von Gradientenmagnetspulen zum Erzeugen linearer Gradientenmagnetfelder enthält. Die Anordnung 10 enthält weiter einen Hochfrequenzsende-und empfangsteil 23, mit dem eine Hochfrequenzspule angesteuert wird. Die beiden Teile 21 und 23 werden von einer zentralen Steuereinheit 25 gesteuert, die im allgemeinen einen Rechner enthalten wird. Die zentrale Steuereinheit 25 steuert weiter eine Signalbearbeitungs-und Signalreproduktionseinheit 27, die über die Hochfrequenzsende-und empfangsanordnung 23 Messsignale empfängt. Die Wirkung der in Fig. 1 dargestellten Anordnung 10, wird anhand eines Messchemas nach Fig. 2 näher erläutert.

Das als Beispiele in Fig. 2 angegebene Messschema oder auch Verfahren enthält eine Anzahl von Messzyklen, von denen nur einer dargestellt ist. Der Messzyklus startet mit einem hochfrequenten 90°-Impuls p1 wonach nach einer Wartezeit tv1 mit einem hochfrequenten 180°-Impuls p2 die Magnetisierungen der angeregten Kernspins invertiert werden, so dass nach einer Wartezeit tv2 (tv2 = tv1) ein Echosignal F2′ erzeugt wird. Im allgemeinen werden in der Vorbereitungszeit zwischen dem 90°-und dem 180°-Impuls p1 und p2 lineare Gradientenmagnetfelder (der deutlichkeitshalber nicht in den Figuren dargestellt) zum Codieren des

abzutastenden Resonanzsignals F2' eingeschaltet. Wenn jedoch keine Gradientenmagnetfelder angelegt werden, erscheint ein Resonanzsignal (F2') ungestört und mit maximaler Stärke. Das ungestörte Erscheinen dieses Maximums bedeutet, dass das Resonanzsignal eine Signaldynamik in der Grössenordnung $2^{20}$ haben kann. Obiges bedeutet, dass an die Empfangseinrichtungen 23 und insbesondere an ihren Analog-Digitalwandlerteil sehr hohe Anforderungen gestellt werden.

Es wird nunmehr ein Ausführungsbeispiel eines erfindungsgemässen Verfahrens angegeben, in dem diese grosse Signaldynamik verringert wird. Bei diesem Ausführungsbeispiel wird nach einem 90°-Impuls p1, mit dem ein Resonanzsignal F1 erzeugt wird, in der Vorbereitungszeit tv1 ein nichtlineares stellenabhängiges zusätzliches Magnetfeld E eingeschaltet. Dieses nicht-linear verlaufende zusätzliche Magnetfeld E bewirkt eine zusätzliche stellenabhängige Phasenzerstreuung des Kernspins. Die Folge davon ist, dass nach einem 180°-Impuls p2 und nach Ablauf eines Zeitraums tv2 (= tv1) die Kernspins zum Kernspinechozeitpunkt T nicht alle in der gleichen Richtung einen Signalbeitrag liefern und daher ein Resonanzsignal F2 erzeugen, dessen Amplitude viel kleiner als die des ungestörten Signals F2' ist. In wieweit eine Streuung in der Phase der verschiedenen Kernspins auftritt, wird durch die Stärke des nicht-linearen zusätzlichen Magnetfelds E und durch die Zeit bestimmt, in der dieses Feld eingeschaltet ist.

In Fig. 2 ist nur ein Zyklus des erfindungsgemässen Verfahrens dargestellt. Das Verfahren kann beispielsweise Messzyklen enthalten, wie sie in der europäischen Patentschrift 074 022 beschrieben sind, wobei dann immer in der Vorbereitungszeit zwischen dem p1-(90°)-und dem p2-(180°)-Hochfrequenzimpuls immer das gleiche nichtlineare zusätzliche Magnetfeld eingeschaltet wird. Selbstverständlich ist die Erfindung auch bei den Verfahren anwendbar, wie sie in der US-PS 4 070 611 oder in der nieder ländischen Patentanmeldung 82 03519 beschrieben wurden.

Der nicht-lineare Verlauf der Stärke des zu erzeugenden zusätzlichen Magnetfelds E ist vorzugsweise parabolisch. Das Magnetfeld E wird mit Zusatzspulen erzeugt, die den bereits erforderlichen Spulen (Hauptfeldspule Bo, Nachstelspulen, Gradientenspulen, Sende (und Empfangs-)spule(n) zugefügt werden. Wie die Zusatzspulen (in Fig. 1 nicht getrennt dargestellt) anzuordnen sind in bezug auf ein zu untersuchendes Objekt, und welche Form diese Zusatzspulen haben sollen, ist beispielsweise der US-PS 3 199 021 zu entnehmen. Obgleich an dieser Literaturstelle Spulen beschrieben werden, die eben zur Beseitigung von Nicht-Linearitäten eines zu erzeugenden homogenen, stationären Magnetfeldes verwendet werden, können sie auch gerade zum Erzeugen gewollter Nicht-Linearitäten verwendet werden (höhere Ordnungs-oder Parabelnichtlinearitäten). Weitere Daten über die Erzeugung (den Ausgleich) nicht linear verlaufender Magnetfelder (höherer Ordnung) sind der US-PS 3 582 779 und der deutschen Patentanmeldung 19 46 059 zu entnehmen. Weiter sei noch bemerkt, dass, wenn derartige Spule ausser den nicht-linear verlaufenden Magnetfeldern auch linear verlaufende Magnetfelder (beispielsweise lineare Gradientenmagnetfelder) erzeugen, können derartige Felder wieder mit von bereits vorhandenen Gradientenspulen zu erzeugenden Magnetfeldern nötigenfalls beseitigt oder ausgeglichen werden.

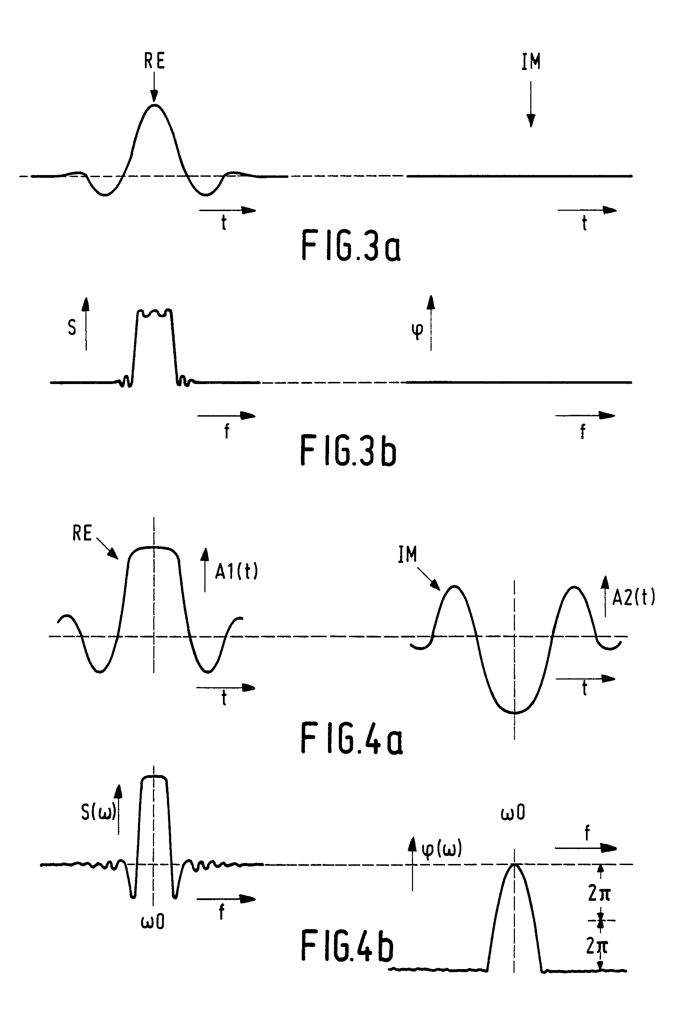

In Fig. 3a und 3b sind ein Hochfrequenzimpuls nach dem Stand der Technik und sein Frequenzgang dargestellt. Die umhüllende Form des Hochfrequenzimpulses in Fig. 3a besitzt eine Gaussche Kurve, auf der eine Sinc-Funktion derart verlegt ist, dass das in Fig. 3b dargestellte Frequenzspektrum f eine ungefähre Rechteckform mit einer Amplitude S besitzt. Obiges bedeutet, dass mit einem derartigen Impuls in der Kombination mit einem Gradientenmagnetfeld ein verhältnismässig scharf abgegrenztes Volumen eines Objekts selektiv anregbar ist. Wie aus Fig. 3 ersichtlich ist die Phase $\phi$ für die verschiedenen Frequenzen f des Spektrums konstant (beispielsweise $\phi = 0$). Das zugeordnete Zeitsignal ist also ein Echtsignal RE und der zugeordnete imaginäre Teil IM ist daher gleich Null, was in Fig. 3a mit einer geraden Linie angegeben ist.

In Fig. 4a ist ein Ausführungsbeispiel eines erfindungsgemässen Hochfrequenzimpulses dargestellt, bei dem das Signal A1(t) die Umhüllende der Echtsignalkomponente RE und das Signal A2(t) die Umhüllende der imaginären Signalkomponente IM sind. Die Signale A2(t) und A1(t) werden wie folgt bestimmt. Im Frequenzgebiet (siehe Fig. 4b) wird ein Frequenzgang gewählt, dessen Amplitudenverlauf S(w)eine Näherung eines Rechtecks ist (um Zusammenhang mit der Randdefinition eines anzuregenden oder zu beeinflussenden Volumens) und also des Frequenzgangs nach Fig. 3b. Bei diesem Frequenzgang S(w) wird eine Phasenkennlinie $\phi$-(w) gewählt, die einen parabolischen Verlauf hat (der maximale Phasenunterschied zwischen einer zentralen Winkelfrequenz Wo und einer Winkelfrequenz Wr "am Rande" kann mehr als (viele Male mehr als) $2\pi$ betragen und ist von der Phasenzerstreuungsgrösse abhängig, die in einem Bildelement gewährt wird). Aus den gewählten Kennlinien S(w) und $\phi$(w) nach Fig. 4b lassen sich mit einem an sich bekannten Rechenverfahren die Umhüllenden A1(t) und A2(t) bestimmen. Die Umhüllenden A1(t) und A2(t) werden zum Erzeugen eines Hochfrequenzimpulses (beispielsweise eines 90°-Impulses; 180°-Impulses) mit einem Hochfrequenzoszillator verwendet, und dieser Hochfrequenzimpuls hat einen nicht linearen Phasenverlauf innerhalb der zu bestimmenden Verteilung.

Die Zerstreuung in einem Bildelement darf nicht zu gross sein, da sonst ein zu hoher Signalverlust auftritt. Es lässt sich errechnen, dass die Zerstreuung in einem Bildelement bei einem parabolischen Phasenverlauf in diesem Bildelement höchstens 90° betragen darf, wenn ein Signalverlust dieses Bildelements von etwa 10% erlaubt wird.

In Fig. 5 ist ein bevorzugtes Ausführungsbeispiel eines Hochfrequenzoszillators 30 für eine Anordnung 10 (Fig. 1) nach der Erfindung dargestellt. Der Hochfrequenzoszillator 30 enthält einen Konstantfrequenzoszillator 31 und einen Quadraturmodulator, der einen 90°-Phasendreher 33, zwei Amplitudenmodulatoren 32 und 34 und einen Addierer 35 enthält. Das im Oszillator 31 erzeugte Hochfrequenzsignal (cos $\omega t$) wird über den 90°-Phasendreher 33 dem Amplitudenmodulator 34 zugeführt. Die Amplitudenmodulatoren 32 und 34 empfangen die Zeitsignale A1(t) bzw. A2(t), wobei A1(t) und A2(t) das wirkliche bzw. das imaginäre Zeitsignal des Fouriertransformierten der im Frequenzspektrum gewählten Funktion sind. Die Addierschaltung 35, die in diesem Fall nur einen Differenzverstärker zu enthalten braucht, empfängt die Ausgangssignale der zwei Modulatoren 32 und 34 und fügt die beiden Signale zusammen. Das Ausgangssignal des Addierers 35 ist gleich

$S(t) = a1(t) \cos \phi t - A2(t) \sin \phi t$

$= Re(A1(t) + iA2(t) \exp(i\phi t)$

und gelangt an die Hochfrequenzspule des Spulensystems 20 (Fig. 1).

## Ansprüche

1. Verfahren zur Bestimmung einer Kernmagnetisierungsverteilung in einem Teil eines Körpers, bei dem ein homogenes statisches Magnetfeld erzeugt wird, in dem sich der Teil des Körpers befindet und
a) ein hochfrequenter elektromagnetischer Impuls zum Erzeugen eines Resonanzsignals erzeugt wird,
b) wobei nach einer Vorbereitungszeit während einer Messzeit eines erzeugten Resonanzsignals eine Anzahl von Signalproben genommen wird,
c) wonach die Schritte a) und b) zum Erhalten einer Gruppe von Signalproben mehrere Male wiederholt werden, aus denen nach der Transformation der Signale ein Bild der Verteilung der Kernmagnetisierung bestimmt wird, dadurch gekennzeichnet, dass mittels eines Magnetfeldes eine innerhalb der Verteilung nicht-linear verlaufende Phasenzerstreuung angeregter Kernmagnetisierungen erzeugt und zum Bestimmen des Bildes der Kernmagnetisierungsverteilung die auf diese Weise erzeugte nicht-lineare verlaufende Phasenzerstreuung ausgeglichen wird.

2. Verfahren nach Anspruch 1, dadurch gekennzeichnet, dass die Verteilung eine stellenabhängige Verteilung ist und dass die Phasenzerstreuung nicht-linear stellenabhängig ist.

3. Verfahren nach Anspruch 1, dadurch gekennzeichnet, dass die Verteilung von einer Spektroskopieverteilung ist und dass die Phasenzerstreuung nicht linear von der Frequenz abhängig ist.

4. Verfahren nach Anspruch 1 oder 2, dadurch gekennzeichnet, dass in der Vorbereitungszeit ein inhomogenes, nicht lineares stellenabhängiges zusätzliches Magnetfeld angelegt wird.

5. Verfahren nach Anspruch 2, dadurch gekennzeichnet, dass die Stärke des zusätzlichen Gradientenmagnetfelds mit zumindest einem der drei zusätzlichen Teilmagnetfelder erzeugt wird, die von je einer der drei senkrecht zueinander verlaufenden Richtungskoordinaten abhängig sind.

6. Verfahren nach Anspruch 4 oder 5, dadurch gekennzeichnet , dass die Stärke jedes zusätzlichen Teilmagnetfelds einen parabolischen Verlauf hat.

7. Verfahren nach Anspruch 1 oder 3, dadurch gekennzeichnet, dass ein benutzter Hochfrequenzimpuls ein nicht-linear verlaufendes Phasenspektrum besitzt.

8. Verfahren nach Anspruch 7, dadurch gekennzeichnet, dass der Hochfrequenzimpuls mit dem nicht-linear verlaufenden Phasenspektrum ein Echoimpuls ist.

9. Verfahren nach Anspruch 7, dadurch gekennzeichnet, dass der Hochfrequenzimpuls mit dem nicht-linear verlaufenden Phasenspektrum ein Anregungsimpuls ist.

10. Verfahren nach Anspruch 8 oder 9, dadurch gekennzeichnet, dass während des Echoimpulses oder des Anregungsimpulses ein Gradientenmagnetfeld angelegt wird.

11. Verfahren nach Anspruch 10, dadurch gekennzeichnet, dass die Gradientenrichtung des während des Hochfrequenzanregungsimpulses und/oder des Echoimpulses vorhandenen Gradientenmagnetfelds mit der Gradientenrichtung eines während der Messzeit anzulegenden Gradientenmagnetfelds zusammenfällt.

12. Verfahren nach Anspruch 7, 8, 9, 10 oder 11, dadurch gekennzeichnet, dass sowohl ein Anregungsimpuls als auch ein erster folgender Echoimpuls ein nicht-linear verlaufendes Phasenspektrum aufweisen, wobei eine Gradientenrichtung eines beim Anregungsimpuls vorhandenen Gradientenfeldes senkrecht zur Gradientenrichtung eines während des Echoimpulses vorhandenen Gradientenfeldes verläuft.

13. Verfahren nach Anspruch 7, 8, 9, 10, 11 oder 12, dadurch gekennzeichnet, dass das nicht linear verlaufende Phasenspektrum parabolisch verläuft.

14. Anordnung zur Bestimmung einer Kernmagnetisierungsverteilung in einem Teil eines Körpers, wobei die Anordnung folgende Mittel enthält:

a) Mittel zum Erzeugen eines statischen homogenen Magnetfelds,

b) Mittel zum Erzeugen einer hochfrequenten elektromagnetischen Strahlung, deren magnetische Feldrichtung senkrecht zur Feldrichtung des homogenen Magnetfeldes gerichtet ist,

c) Mittel zum Erzeugen eines Gradientenmagnetfeldes,

d) Abtastmittel zum Abtasten eines mit den unter a) und b) genannten Mitteln erzeugten Resonanzsignals,

e) Verarbeitungsmittel zum Verarbeiten der von den Abtastmitteln erzeugten Signale zu einem Bild der Kernmagnetisierungsverteilung und

f) Steuermittel zum Steuern zumindest der unter b) bis e) genannten Mittel zum Erzeugen, Konditionieren, Abtasten und Verarbeiten einer Anzahl von Resonanzsignalen,

dadurch gekennzeichnet, dass die Anordnung weiter Mittel zum Erzeugen einer innerhalb der Verteilung nicht linear verlaufenden Phasenzerstreuung angeregter Kernmagnetisierungen und weiter Mittel zum Ausgleichen dieser Phasenzerstreuung enthält.

15. Anordnung nach Anspruch 14, dadurch gekennzeichnet , dass die Mittel zum Erzeugen einer innerhalb der Kernmagnetisierungsverteilung nichtlinear verlaufenden Phasenzerstreuung zumindest eine Spule zum Erzeugen eines nicht-linear stellenabhängigen, zusätzlichen Magnetfelds enthalten.

16. Anordnung nach Anspruch 14, dadurch gekennzeichnet, dass die Anordnung Hochfrequenzmittel zum Erzeugen von Hochfrequenzimpulsen mit einem nicht-linear verlaufenden Phasenspektrum enthält.

17. Anordnung nach Anspruch 16, dadurch gekennzeichnet, dass die Hochfrequenzmittel einen Einseitenbandmodulator enthalten.

18. Anordnung nach Anspruch 14, 15, 16 oder 17, dadurch gekennzeichnet, dass die Anordnung Speichermittel zum Speichern von Werten zum Ausgleichen der Zerstreuungen enthält.

19. Anordnung nach Anspruch 18, dadurch gekennzeich net , dass die Speichermittel zum Speichern der Ausgleichswerte eine Anzahl von Speicherstellen enthalten, die gleich der Anzahl von Bildelementen in einer Dimensionsrichtung eines mehrdimensionalen Bildes ist.

20. Anordnung nach Anspruch 18, dadurch gekennzeichnet, dass die Speichermittel zum Speichern von Ausgleichswerten eine Anzahl von Speicherstellen gleich der Anzahl von Bildelementen eines zu bestimmenden Bildes der Verteilung enthalten.

FIG.1

FIG.2

FIG.5

FIG.3a

FIG.3b

FIG.4a

FIG.4b

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | US-A-4 034 191 (TOMLINSON et al.)<br>* Spalte 11, Zeilen 45-62; Spalte 13, Zeile 26 - Spalte 14, Zeile 2 * <br><br>--- | 1,7-10 ,14-18 | G 01 N 24/08 |
| Y | EP-A-0 164 142 (N.V. PHILIPS' GLOEILAMPENFABRIEKEN)<br><br>* Seite 4, Zeile 8 - Seite 5, Zeile 12 *<br><br>--- | 1-3,7-12,14-18 | |
| A | EP-A-0 165 057 (TOSHIBA K.K.)<br>* Seite 5, Zeilen 4-9; Seite 6, Zeile 18 - Seite 8, Zeile 27 *<br><br>--- | 1 | |
| A | MEDICAL PHYSICS, Band 12, Nr. 4, Juli/August 1985, Seiten 413-418, Am. Assoc. Phys. Med., New York, US; D.G. NISHIMURA: "A multiple-pulse sequence for improved selective excitation in magnetic resonance imaging"<br>* Seite 416, linke Spalte, Zeilen 26-42; Abschnitt, "Discussion" *<br><br>--- | 1,7 | **RECHERCHIERTE SACHGEBIETE (Int. Cl.4)**<br><br>G 01 N 24/00 |
| A | EP-A-0 177 990 (N.V. PHILIPS' GLOEILAMPENFABRIEKEN)<br>* Seite 6, Zeile 12 - Seite 7, Zeile 38 *<br><br>--- -/- | 1-12 | |

Der vorliegende Recherchenbericht wurde für alle Patentansprüche erstellt.

| Recherchenort | Abschlußdatum der Recherche | Prüfer |
|---|---|---|
| DEN HAAG | 27-07-1987 | DIOT P.M.L. |

Europäisches
Patentamt

**EUROPÄISCHER RECHERCHENBERICHT**

Nummer der Anmeldung

EP 87 20 C667

Seite 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | PATENT ABSTRACTS OF JAPAN, Band 7, Nr. 256 (P-236) 1401 , 15. November 1983; & JP-A-58 140 629 (HITACHI SEISAKUSHO K.K.) 20-08-1983 * Zusammenfassung * | 1,14, 16 | |
| | --- | | |
| A | IEEE TRANSACTIONS ON NUCLEAR SCIENCE, Band NS-32, Nr. 1, Februar 1985, Seiten 799-802, IEEE, New York, US; K. SEKIHARA et al.: "A new method of measuring static field distribution using NMR images" * Abschnitte 3,4 * | 1 | |
| | --- | | |
| A | MEDICAL PHYSICS, Band 12, Nr. 1, Januar/Februar 1985, Seiten 20-26, Am. Assoc. Phys. Med., New York, US; M. O'DONNELL et al.: "NMR imaging in the presence of magnetic field inhomogeneities and gradient field nonlinearities" * Abschnitt III * | 1,4,14 ,18-20 | RECHERCHIERTE SACHGEBIETE (Int. Cl.4) |
| | ----- | | |

Der vorliegende Recherchenbericht wurde für alle Patentansprüche erstellt.

| Recherchenort | Abschlußdatum der Recherche | Prüfer |
|---|---|---|
| DEN HAAG | 27-07-1987 | DIOT P.M.L. |